# EUROPEAN PATENT APPLICATION

(11) **EP 4 793 935 A1**
(43) Date of publication of application: **19.08.2026**
(21) Application number: 26151560.5
(22) Date of filing: 13.01.2026
(51) Int. Cl.: G09G 3/3266, G09G 3/3233, G11C 19/28

(54) **GATE DRIVER, DISPLAY DEVICE INCLUDING THE GATE DRIVER, AND ELECTRONIC APPARATUS INCLUDING THE DISPLAY DEVICE**

(30) Priority: 22.01.2025 KR 20250009194
(71) Applicant: Samsung Display Co., Ltd., Yongin-si, Gyeonggi-do 17113 (KR); IUCF-HYU (Industry-University Cooperation Foundation Hanyang University), Seoul (KR)
(72) Inventor: Kim, Sanghun, Yongin-si, Gyeonggi-do (KR); Kwon, Oh Kyong, 06001 Seoul (KR); Keum, Nackhyeon, Yongin-si, Gyeonggi-do (KR); Kim, Kyung-Hoon, Yongin-si, Gyeonggi-do (KR); Wee, Sung Min, 04561 Seoul (KR); Jang, Jun Hyeok, Seoul (KR); Song, Heerim, Yongin-si, Gyeonggi-do (KR)
(74) Representative: Gulde & Partner

(57) **Abstract**

The present invention relates to a gate driver (10, 1042) including stages (ST). Each of the stages (ST) includes an input transistor (M1) that transmits an input signal (IN) to a Q node in response to a clock signal (CLK), a pull-up transistor (M5) that outputs a high gate voltage (VGH) as an output signal (OUT) in response to a signal of a QB node, a first pull-down transistor (M5) that outputs a low gate voltage (LGV) as the output signal (OUT) in response to a signal of the Q node, a first control transistor (M9) that transmits a signal of a QB node of a previous stage (ST) to a B node in response to the signal of the Q node, and a second pull-down transistor (M11) that outputs the low gate voltage (LGV) as the output signal (OUT) in response to a signal of the B node.

## Description

### TECHNICAL FIELD

Embodiments relate to a gate driver including transistors and capacitors, a display device including the gate driver, and an electronic apparatus including the display device.

### DISCUSSION OF RELATED ART

A display device may include a display panel, a gate driver, and a data driver. The display panel may include pixels, the gate driver may provide gate signals to the pixels, and the data driver may provide data voltages to the pixels.

The gate driver may include stages that output the gate signals. The stages may be implemented as shift registers that generate the gate signals by sequentially shifting a gate start signal. Each of the stages may include multiple transistors and multiple capacitors.

### SUMMARY

Embodiments provide a gate driver in which reliability of an output signal is improved and power consumption is reduced, a display device including the gate driver, and an electronic apparatus including the display device.

According to an embodiment of the disclosure, a gate driver includes a plurality of stages. Each of the plurality of stages includes an input transistor configured to transmit an input signal to a Q node in response to a clock signal, and an output terminal to output an output signal, the output terminal is disposed between a pull-up transistor and each of a first pull-down transistor and a second pull-down transistor. The pull-up transistor is configured to output a high gate voltage as the output signal in response to a signal of a QB node where the QB node is connected to a gate of the pull-up transistor. The first pull-down transistor is configured to output a low gate voltage as the output signal in response to a signal of the Q node. The second pull-down transistor is configured to output the low gate voltage as the output signal in response to a signal of a B node where the B node is connected to a gate of the second pull down transistor. Each stage may also include a first control transistor configured to transmit a signal of a QB node of a previous stage to the B node in response to the signal of the Q node where the Q node is connected to both of a gate of the first pull-down transistor and a gate of the first control transistor.

According to an embodiment, each of the stages may further include a second control transistor that may include a gate configured to receive the clock signal, a first terminal configured to receive the clock signal, and a second terminal connected to a C node.

According to an embodiment, each of the stages may further include a third control transistor that may be configured to connect the QB node to the C node in response to the signal of the B node.

According to an embodiment, for a case in which the input signal has the high gate voltage and the clock signal has the low gate voltage, a voltage corresponding to a sum of the low gate voltage and a threshold voltage of the second control transistor may be applied to the QB node through the second control transistor and the third control transistor.

According to an embodiment, each of the stages may further include a third capacitor that may be connected between the B node and the C node.

According to an embodiment, each of the stages may further include a fourth control transistor that may be configured to transmit the high gate voltage to the QB node in response to the signal of the Q node.

According to an embodiment, each of the stages further may include a first protection transistor that may include a gate configured to receive the low gate voltage, a first terminal connected to a second terminal of the input transistor, and a second terminal connected to the Q node.

According to an embodiment, each of the stages may further include a second protection transistor that may include a gate configured to receive the low gate voltage, a first terminal connected to a second terminal of the first control transistor, and a second terminal connected to the B node.

According to an embodiment, each of the stages may further include a reset transistor that may be configured to transmit the low gate voltage to the Q node in response to a reset signal.

According to an embodiment, each of the stages may further include a first capacitor that may include a first terminal connected to the QB node and a second terminal configured to receive the high gate voltage.

According to an embodiment, each of the stages may further include a second capacitor that may include a first terminal connected to the Q node and a second terminal connected to an output terminal configured to output the output signal.

According to an embodiment, for a case in which the input signal has the low gate voltage, the clock signal has the low gate voltage, and the output signal transitions from the high gate voltage to the low gate voltage, the signal of the Q node may transition from the high gate voltage to a voltage lower than the low gate voltage.

According to an embodiment, each of the stages may further include a second control transistor that may include a gate connected to the B node, a first terminal configured to receive the clock signal, and a second terminal.

According to an embodiment, each of the stages may further include a third control transistor that may include a gate connected to the second terminal of the second control transistor, a first terminal connected to the second terminal of the second control transistor, and a second terminal connected to the QB node.

According to an embodiment, each of the stages may further include a third capacitor that may be connected between the B node and the QB node.

According to an embodiment, the second pull-down transistor may be an n-type metal oxide semiconductor (NMOS) transistor, and each of transistors included in each of the stages excluding the second pull-down transistor may be a p-type metal oxide semiconductor (PMOS) transistor.

A display device according an embodiment includes a display panel including pixel rows each including pixels and a gate driver including stages configured to output gate signals to the pixel rows. Each of the stages includes an input transistor configured to transmit an input signal to a Q node in response to a clock signal, and an output terminal to output an output signal, the output terminal is disposed between a pull-up transistor and each of a first pull-down transistor and a second pull-down transistor. The pull-up transistor is configured to output a high gate voltage as an output signal in response to a signal of a QB node where the QB node is connected to a gate of the pull-up transistor. The first pull-down transistor is configured to output a low gate voltage as the output signal in response to a signal of the Q node where the second pull-down transistor is configured to output the low gate voltage as the output signal in response to a signal of a B node and the B node is connected to a gate of the second pull down transistor. Each stage also includes a first control transistor configured to transmit a signal of a QB node of a previous stage to the B node in response to the signal of the Q node where the Q node is connected to both of a gate of the first pull-down transistor and a gate of the first control transistor and where the first pull-down transistor and the second pull-down transistor are connected in parallel to each other.

According to an embodiment, each of the pixels may include a first transistor including a gate connected to a first node, a first terminal connected to a second node, and a second terminal connected to a third node, may include a second transistor that may be configured to transmit a data voltage to the second node in response to a write gate signal, may include a third transistor configured to connect the first node to the third node in response to a compensation gate signal, may include a fourth transistor that may be configured to transmit a first initialization voltage to the first node in response to an initialization gate signal, may include a fifth transistor that may be configured to transmit a first power voltage to the second node in response to an emission control signal, may include a sixth transistor that may be configured to connect the third node to a fourth node in response to the emission control signal, may include a seventh transistor that may be configured to transmit a second initialization voltage to the fourth node in response to a bypass gate signal, may include a storage capacitor that may be connected between the first node and a power line configured to transmit the first power voltage, and may include a light-emitting element that may include a first terminal connected to the fourth node and a second terminal configured to receive a second power voltage. The output signal may be one of the compensation gate signal, the initialization gate signal, the bypass gate signal, and the emission control signal.

According to an embodiment, the first pull-down transistor and the second pull-down transistor may be connected in parallel.

According to an embodiment of the disclosure, an electronic apparatus including a display device and a processor configured to control the display device according to embodiments, the display device includes a display panel including pixel rows each including pixels and a gate driver including stages configured to output gate signals to the pixel rows. Each of the stages includes an input transistor configured to transmit an input signal to a Q node in response to a clock signal, and an output terminal to output an output signal, the output terminal is disposed between a pull-up transistor and each of a first pull-down transistor and a second pull-down transistor. The pull-up transistor is configured to output a high gate voltage as the output signal in response to a signal of a QB node where the QB node is connected to a gate of the pull-up transistor. The first pull-down transistor is configured to output a low gate voltage as the output signal in response to a signal of the Q node. the second pull-down transistor is configured to output the low gate voltage as the output signal in response to a signal of a B node, the B node is connected to a gate of the second pull down transistor. Each stage also includes a first control transistor configured to transmit a signal of a QB node of a previous stage to the B node in response to the signal of the Q node where the Q node is connected to both of a gate of the first pull-down transistor and a gate of the first control transistor and where the first pull-down transistor and the second pull-down transistor are connected in parallel to each other.

In the gate driver, the display device, and the electronic apparatus that include the gate driver, the output signal of the gate driver does not have an intermediate voltage level between the high gate voltage and the low gate voltage, and the output signal does not rise to a level higher than the low gate voltage in a period in which the output signal has the low voltage level, so that the reliability of the output signal may be improved. Further, even if the signal of the Q node rises to the low gate voltage due to leakage current of the input transistor and the first protection transistor, the output signal is maintained at the low gate voltage by the second pull-down transistor, so that low-frequency driving of the display device may be supported, and the power consumption of the display device may be reduced. Further, even if the second pull-down transistor operates in a depletion mode, since the signal of the B node has the second low gate voltage, the second pull-down transistor may be turned off, and accordingly, additional power might not be consumed, and reliability of the operation of the oxide transistor may be secured. Further, the gate driver is driven by only two power voltages (the high gate voltage and the low gate voltage), so that complexity of a power voltage generator may be reduced, and complexity of a layout of the gate driver due to an additional power line may be reduced. Further, a current flowing in the pull-up transistor and the first pull-down transistor that output the output signal is reduced, so that the power consumption of the gate driver may be reduced.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

Illustrative, non-limiting embodiments will be more clearly understood from the following detailed description taken in conjunction with the accompanying drawings.
FIG. 1 is a block diagram illustrating a gate driver according to an embodiment;
FIG. 2 is a circuit diagram illustrating an example of a stage included in the gate driver of FIG. 1 according to an embodiment;
FIG. 3 is a timing diagram illustrating signals of the stage of FIG. 2 according to an embodiment;
FIGS. 4 to 8 are diagrams for describing operation of the stage of FIG. 2 according to an embodiment;
FIG. 9 is a circuit diagram illustrating an example of the stage included in the gate driver of FIG. 1 according to an embodiment;
FIG. 10 is a circuit diagram illustrating an example of the stage included in the gate driver of FIG. 1 according to an embodiment;
FIG. 11 is a block diagram illustrating a display device according to an embodiment;
FIG. 12 is a circuit diagram illustrating a pixel of FIG. 11 according to an embodiment; and
FIG. 13 is a block diagram illustrating an electronic apparatus according to an embodiment.

### DETAILED DESCRIPTION OF THE EMBODIMENTS

While each drawing may represent one or more particular embodiments of the present disclosure, drawn to scale, such that the relative lengths, thicknesses, and angles can be inferred therefrom, it is to be understood that the disclosure is not necessarily limited to the relative lengths, thicknesses, and angles shown. Changes to these values may be made within the scope of the present disclosure as defined by the appended claims, for example, to allow for manufacturing limitations and the like.

Embodiments of the disclosure relate to a gate driver, a display device that includes the same and an electronic apparatus that includes the same where the gate driver includes multiple stages. Each of the stages may include a circuit that avoids outputting an intermediate voltage between a high gate voltage VGH and a low gate voltage VGL so that reliability is improved. The stage circuit may include an output terminal disposed between a pull-up transistor M5 and pull-down transistors M6 and M11. Second pull-down transistor M11 may be included to prevent the output voltage from rising above a low voltage level to an intermediate level, the second pull-down transistor M11 may be electrically connected in parallel with the first pull-down transistor M6. The stage circuit may include a QB node that is a control node for (i.e., connected to the gate of) the pull-up transistor M5, a Q node connected to the gate of the first pull-down transistor M6, and a B node connected to the gate of the second pull-down transistor M11.

Upon being driven in low frequency driving where the control (or Q) node of the first pull down transistor M6 may rise to a low gate voltage VGL due to leakage current of input transistors M1 and M7, the output signal OUT may still be maintained at the low gate voltage VGL. For a case in which the second pull-down transistor M11 is operated in depletion mode, a signal of B node may have a second low gate voltage 2VGL to turn off the second pull-down transistor M11 to reduce static current flowing through second pull-down transistor M11 to conserve power. Also, a third voltage is not required to drive the gate driver, thereby reducing complexity of a power voltage generator.

Hereinafter, a gate driver, a display device, and an electronic apparatus according to embodiments of the disclosure will be described in more detail with reference to the accompanying drawings. The same or similar reference numerals will be used for the same elements in the accompanying drawings.

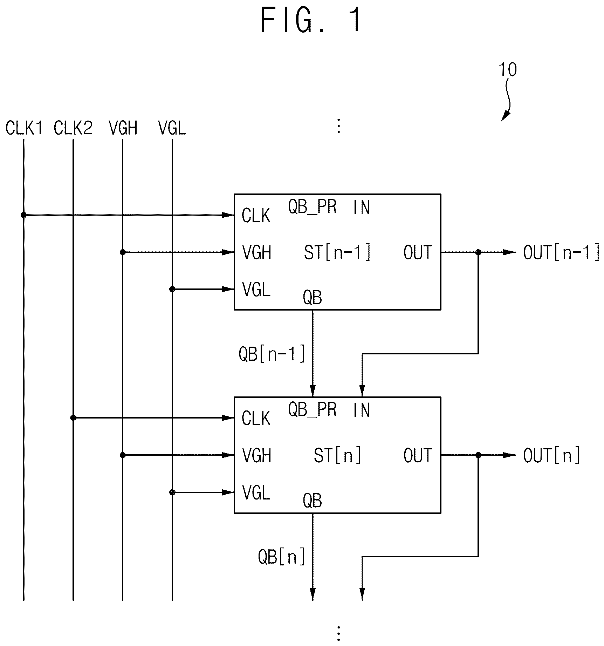

FIG. 1 is a block diagram illustrating a gate driver 10 according to an embodiment.

Referring to FIG. 1, the gate driver 10 may receive a high gate voltage VGH, a low gate voltage VGL, a first clock signal CLK1, a second clock signal CLK2, and a gate start signal, and may output multiple output signals ..., OUT[n-1], OUT[n], .... The high gate voltage VGH may be a turn-off voltage of a p-type metal oxide semiconductor (PMOS) transistor and a turn-on voltage of an n-type metal oxide semiconductor (NMOS) transistor. The low gate voltage VGL may be a turn-on voltage of the PMOS transistor and a turn-off voltage of the NMOS transistor. A voltage level of the low gate voltage VGL may be lower than a voltage level of the high gate voltage VGH.

The second clock signal CLK2 may be a signal in which the first clock signal CLK1 is shifted by half a period of the first clock signal CLK1. Each of the first clock signal CLK1 and the second clock signal CLK2 may cycle (or alternate) between the high gate voltage VGH and the low gate voltage VGL.

The gate driver 10 may include multiple stages ..., ST[n-1], ST[n], ... including an n-1^{th} stage ST[n-1] and an n^{th} stage ST[n], where n is a natural number greater than or equal to 2. The stages ..., ST[n-1], ST[n], ... may be implemented as shift registers that output output signals ..., OUT[n-1], OUT[n], ... in which a gate start signal is sequentially shifted.

Each of the stages ..., ST[n-1], ST[n], ... may receive a clock signal CLK, the high gate voltage VGH, the low gate voltage VGL, a signal of a previous QB node QB_PR, and an input signal IN, and may output a signal of a QB node and an output signal OUT. The n-1^{th} stage ST[n-1] may receive the first clock signal CLK1 as the clock signal CLK, may receive a signal of a QB node of an n-2^{th} stage, may receive an output signal of the n-2^{th} stage as the input signal IN, may output a signal of a QB node QB[n-1], and may output an n-1^{th} output signal OUT[n-1]. The n^{th} stage ST[n] may receive the second clock signal CLK2 as the clock signal CLK, may receive a signal of the QB node QB[n-1] of the n-1^{th} stage ST[n-1], may receive the output signal OUT[n-1] of the n-1^{th} stage ST[n-1] as the input signal IN, may output a signal of a QB node QB[n], and may output an n^{th} output signal OUT[n].

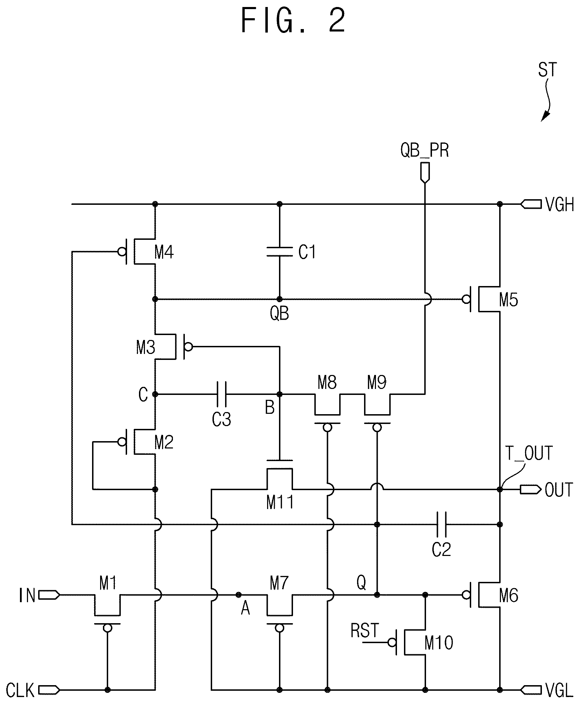

FIG. 2 is a circuit diagram illustrating an example of a stage ST included in the gate driver 10 of FIG. 1.

Referring to FIG. 2, the stage ST may include an input transistor M1, a second control transistor M2, a third control transistor M3, a fourth control transistor M4, a pull-up transistor M5, a first pull-down transistor M6, a first protection transistor M7, a second protection transistor M8, a first control transistor M9, a reset transistor M10, a second pull-down transistor M11, a first capacitor C1, a second capacitor C2, and a third capacitor C3.

The input transistor M1 may transmit the input signal IN to a Q node in response to the clock signal CLK. The input transistor M1 may include a gate that receives the clock signal CLK, a first terminal that receives the input signal IN, and a second terminal connected to an A node. The first terminal of the input transistor M1 may be a first of a source and a drain, and the second terminal of the input transistor M1 may be another of the source and the drain.

The second control transistor M2 may include a gate that receives the clock signal CLK, a first terminal that receives the clock signal CLK, and a second terminal connected to a C node. The first terminal of the second control transistor M2 may be a first of a source and a drain, and the second terminal of the second control transistor M2 may be another of the source and the drain. The second control transistor M2 may be diode-connected. For a case in which the clock signal CLK has the low gate voltage VGL, a voltage corresponding to the sum of the low gate voltage VGL and a threshold voltage of the second control transistor M2 may be applied to the C node.

The third control transistor M3 may connect the QB node and the C node in response to a signal of a B node. The third control transistor M3 may include a gate connected to the B node, a first terminal connected to the C node, and a second terminal connected to the QB node. The first terminal of the third control transistor M3 may be a first of a source and a drain, and the second terminal of the third control transistor M3 may be another of the source and the drain.

The fourth control transistor M4 may transmit the high gate voltage VGH to the QB node in response to a signal of the Q node. The fourth control transistor M4 may include a gate connected to the Q node, a first terminal that receives the high gate voltage VGH, and a second terminal connected to the QB node. The first terminal of the fourth control transistor M4 may be a first of a source and a drain, and the second terminal of the fourth control transistor M4 may be another of the source and the drain.

The pull-up transistor M5 may output the high gate voltage VGH as the output signal OUT in response to a signal of the QB node. The pull-up transistor M5 may include a gate connected to the QB node, a first terminal that receives the high gate voltage VGH, and a second terminal connected to an output terminal T_OUT that outputs the output signal OUT. The first terminal of the pull-up transistor M5 may be a first of a source and a drain, and the second terminal of the pull-up transistor M5 may be another of the source and the drain.

The first pull-down transistor M6 may output the low gate voltage VGL as the output signal OUT in response to the signal of the Q node. The first pull-down transistor M6 may include a gate connected to the Q node, a first terminal that receives the low gate voltage VGL, and a second terminal connected to the output terminal T_OUT. The first terminal of the first pull-down transistor M6 may be a first of a source and a drain, and the second terminal of the first pull-down transistor M6 may be another of the source and the drain.

The first protection transistor M7 may include a gate that receives the low gate voltage VGL, a first terminal connected to the A node, and a second terminal connected to the Q node. The first terminal of the first protection transistor M7 may be a first of a source and a drain, and the second terminal of the first protection transistor M7 may be another of the source and the drain. For a case in which a second low gate voltage lower than a voltage level of the low gate voltage VGL is applied to the Q node, the first protection transistor M7 may protect the input transistor M1 by allowing a voltage higher than a voltage level of the second low gate voltage to be applied to the A node.

The second protection transistor M8 may include a gate that receives the low gate voltage VGL, a first terminal connected to a second terminal of the first control transistor M9, and a second terminal connected to the B node. The first terminal of the second protection transistor M8 may be a first of a source and a drain, and the second terminal of the second protection transistor M8 may be another of the source and the drain. For a case in which the second low gate voltage is applied to the B node, the second protection transistor M8 may protect the first control transistor M9 by allowing a voltage higher than the voltage level of the second low gate voltage to be applied to the second terminal of the first control transistor M9.

The first control transistor M9 may transmit the signal of the QB node QB_PR of a previous stage to the B node in response to the signal of the Q node. The first control transistor M9 may include a gate connected to the Q node, a first terminal that receives the signal of the QB node QB_PR of the previous stage, and a second terminal connected to the first terminal of the second protection transistor M8. The first terminal of the first control transistor M9 may be a first of a source and a drain, and the second terminal of the first control transistor M9 may be another of the source and the drain.

The reset transistor M10 may transmit the low gate voltage VGL to the Q node in response to a reset signal RST. The reset transistor M10 may include a gate that receives the reset signal RST, a first terminal that receives the low gate voltage VGL, and a second terminal connected to the Q node. The first terminal of the reset transistor M10 may be a first of a source and a drain, and the second terminal of the reset transistor M10 may be another of the source and the drain.

The second pull-down transistor M11 may output the low gate voltage VGL as the output signal OUT in response to the signal of the B node. The second pull-down transistor M11 may include a gate connected to the B node, a first terminal that receives the low gate voltage VGL, and a second terminal connected to the output terminal T_OUT. The first terminal of the second pull-down transistor M11 may be a first of a source and a drain, and the second terminal of the second pull-down transistor M11 may be another of the source and the drain.

In an embodiment, the second pull-down transistor M11 may be an NMOS transistor, and each of the transistors M1, M2, M3, M4, M5, M6, M7, M8, M9, and M10 included in the stage ST excluding the second pull-down transistor M11 may be a PMOS transistor. In an embodiment, the second pull-down transistor M11 may be an oxide semiconductor transistor, and each of the transistors M1, M2, M3, M4, M5, M6, M7, M8, M9, and M10 included in the stage ST excluding the second pull-down transistor M11 may be a polycrystalline silicon transistor.

The first capacitor C1 may be connected between the QB node and a line that transmits the high gate voltage VGH. The first capacitor C1 may include a first terminal connected to the QB node and a second terminal that receives the high gate voltage VGH. The first capacitor C1 may store the signal of the QB node.

The second capacitor C2 may be connected between the Q node and the output terminal T_OUT. The second capacitor C2 may include a first terminal connected to the Q node and a second terminal connected to the output terminal T_OUT. The second capacitor C2 may store the signal of the Q node. Further, the second capacitor C2 may bootstrap the signal of the Q node for a case in which a voltage level of the output voltage OUT changes.

The third capacitor C3 may be connected between the B node and the C node. The third capacitor C3 may include a first terminal connected to the B node and a second terminal connected to the C node. The third capacitor C3 may bootstrap the signal of the B node when a signal of the C node changes.

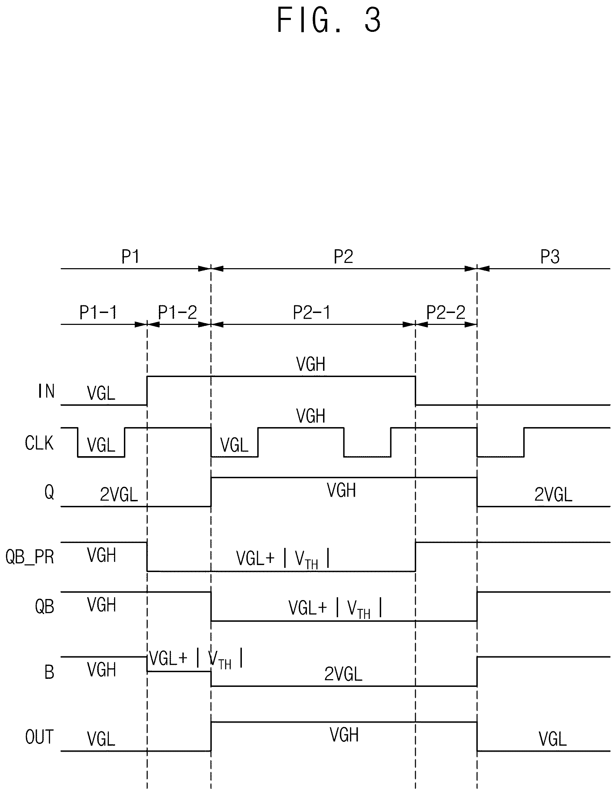

FIG. 3 is a timing diagram illustrating signals of the stage ST of FIG. 2.

Referring to FIGS. 2 and 3, an operation period of the stage ST may include a first period P1, a second period P2, and a third period P3. The first period P1 may include a first-first period P1-1 and a first-second period P1-2, and the second period P2 may include a second-first period P2-1 and a second-second period P2-2.

The input signal IN may have the low gate voltage VGL in the first-first period P1-1, may have the high gate voltage VGH in the first-second period P1-2 and the second-first period P2-1, and may have the low gate voltage VGL in the second-second period P2-2 and the third period P3. The clock signal CLK may have the high gate voltage VGH and the low gate voltage VGL which are alternating. The signal of the QB node QB_PR of the previous stage may have the high gate voltage VGH in the first-first period P1-1, may have a voltage VGL+|V_{TH}| corresponding to the sum of the low gate voltage VGL and the threshold voltage V_{TH} of the second control transistor M2 in the first-second period P1-2 and the second-first period P2-1, and may have the high gate voltage VGH in the second-second period P2-2 and the third period P3.

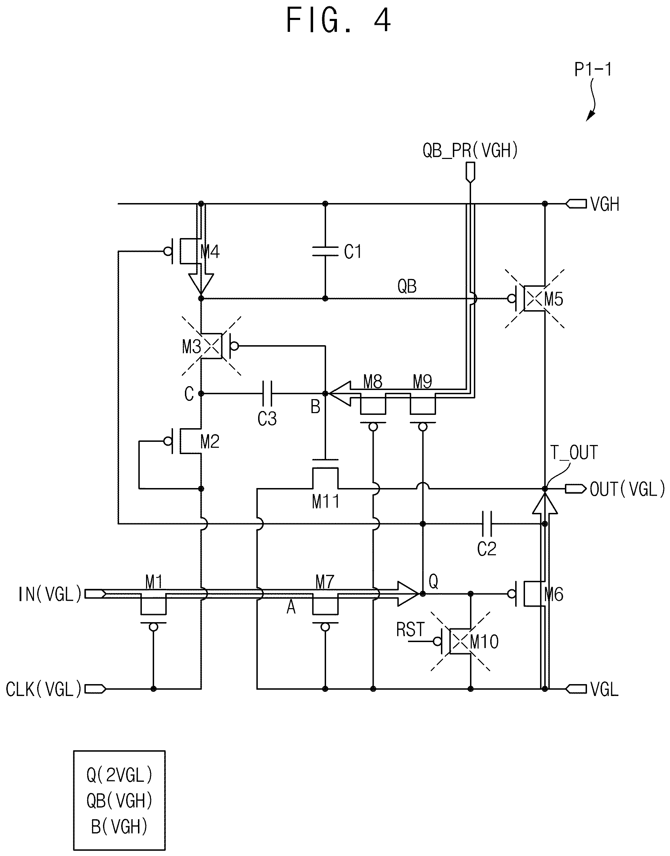

FIGS. 4 to 8 are diagrams for describing operation of the stage ST of FIG. 2.

Referring to FIGS. 3 and 4, in the first-first period P1-1, the input transistor M1, the second control transistor M2, the fourth control transistor M4, the first pull-down transistor M6, the first protection transistor M7, the second protection transistor M8, the first control transistor M9, and the second pull-down transistor M11 may be turned on. The low gate voltage VGL may be applied to the A node and the Q node through the input transistor M1 and the first protection transistor M7. The output signal OUT may have the low gate voltage VGL through the first pull-down transistor M6. The signal of the Q node may have the second low gate voltage 2VGL lower than the voltage level of the low gate voltage VGL by the bootstrap of the second capacitor C2. The high gate voltage VGH may be applied to the B node through the first control transistor M9 and the second protection transistor M8. The high gate voltage VGH may be applied to the QB node through the fourth control transistor M4.

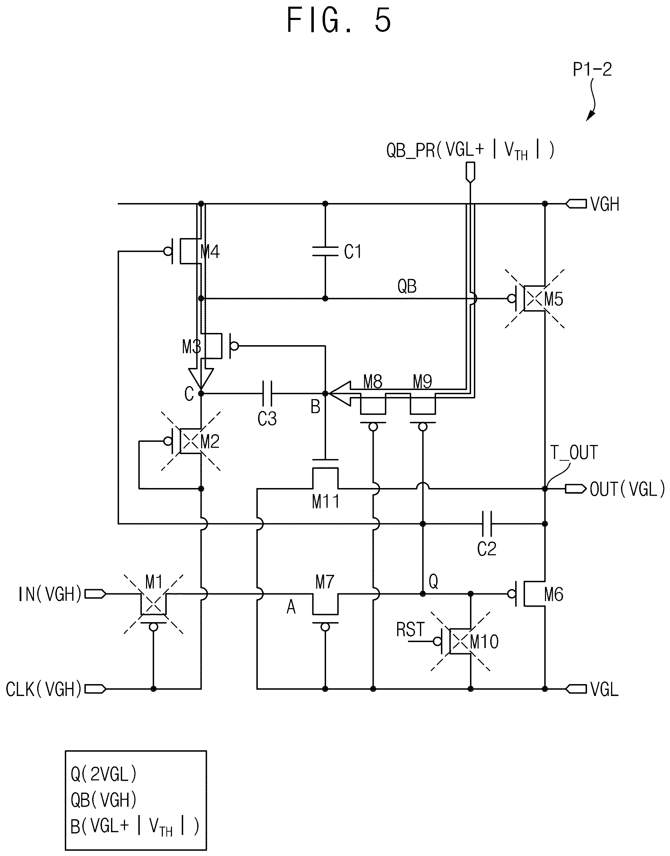

Referring to FIGS. 3 and 5, in the first-second period P1-2, the third control transistor M3, the fourth control transistor M4, the first pull-down transistor M6, the first protection transistor M7, the second protection transistor M8, the first control transistor M9, and the second pull-down transistor M11 may be turned on. The output signal OUT may be maintained at the low gate voltage VGL. The voltage VGL+|V_{TH}| corresponding to the sum of the low gate voltage VGL and the threshold voltage V_{TH} of the second control transistor M2 may be applied to the B node through the first control transistor M9 and the second protection transistor M8. The high gate voltage VGH may be applied to the C node through the fourth control transistor M4 and the third control transistor M3.

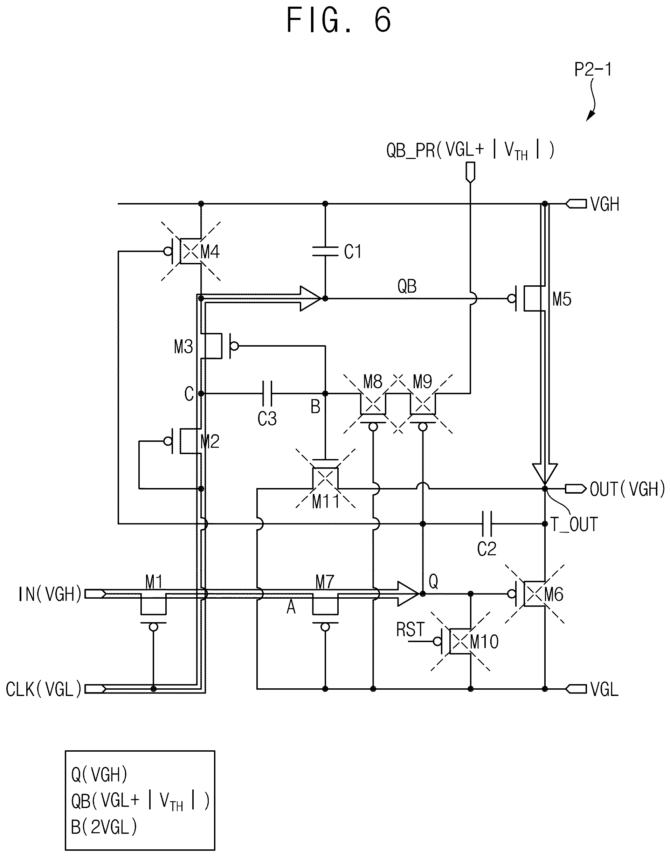

Referring to FIGS. 3 and 6, in the second-first period P2-1, the input transistor M1, the second control transistor M2, the third control transistor M3, the pull-up transistor M5, and the first protection transistor M7 may be turned on. The high gate voltage VGH may be applied to the A node and the Q node through the input transistor M1 and the first protection transistor M7. The voltage VGL+|V_{TH}| corresponding to the sum of the low gate voltage VGL and the threshold voltage V_{TH} of the second control transistor M2 may be applied to the C node and the QB node through the second control transistor M2 and the third control transistor M3. The signal of the B node may have the second low gate voltage 2VGL by the bootstrap of the third capacitor C3. The output signal OUT may have the high gate voltage VGH through the pull-up transistor M5.

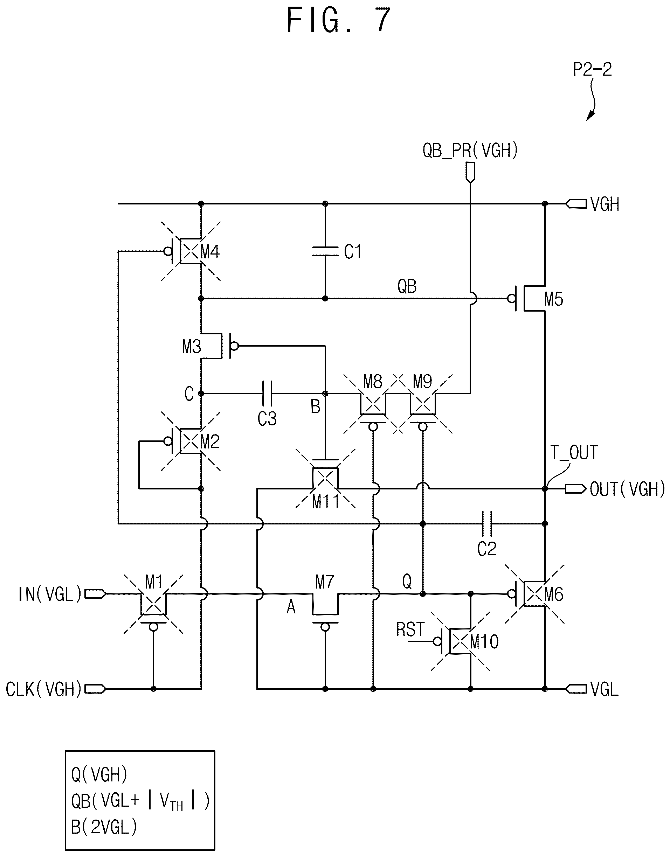

Referring to FIGS. 3 and 7, in the second-second period P2-2, the third control transistor M3, the pull-up transistor M5, and the first protection transistor M7 may be turned on. Since the input signal IN transitions to the low gate voltage VGL but the clock signal CLK has the high gate voltage VGH, the input transistor M1 may be turned off, and accordingly, the signals of the nodes Q, QB, A, B, and C and the output signal OUT may maintain their states in the second-first period P2-1.

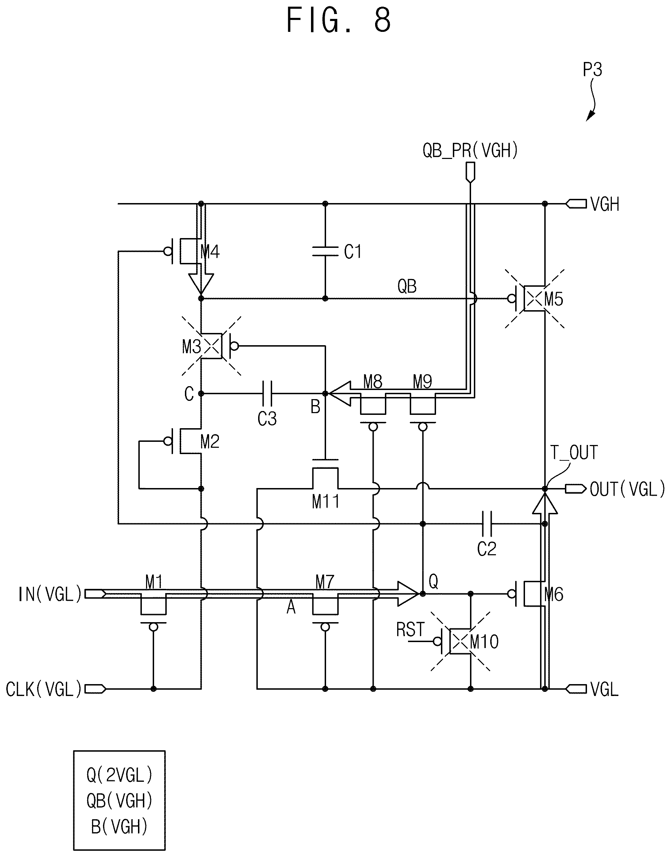

Referring to FIGS. 3 and 8, in the third period P3, the input transistor M1, the second control transistor M2, the fourth control transistor M4, the first pull-down transistor M6, the first protection transistor M7, the second protection transistor M8, the first control transistor M9, and the second pull-down transistor M11 may be turned on. The low gate voltage VGL may be applied to the A node and the Q node through the input transistor M1 and the first protection transistor M7. The output signal OUT may have the low gate voltage VGL through the first pull-down transistor M6. The signal of the Q node may have the second low gate voltage 2VGL by the bootstrap of the second capacitor C2. The high gate voltage VGH may be applied to the B node through the first control transistor M9 and the second protection transistor M8. The high gate voltage VGH may be applied to the QB node through the fourth control transistor M4.

In the embodiment, in the third period P3, the signal of the Q node may transition from the high gate voltage VGH to the second low gate voltage 2VGL at once, and accordingly, the output voltage OUT may transition from the high gate voltage VGH to the low gate voltage VGL at once. Accordingly, the output signal OUT might not have an intermediate voltage between the high gate voltage VGH and the low gate voltage VGL, and thus, the reliability of the output signal OUT may be improved.

In the embodiment, in the second period P2, the voltage VGL+|V_{TH}| corresponding to the sum of the low gate voltage VGL and the threshold voltage V_{TH} of the second control transistor M2, which is higher than the voltage level of the low gate voltage VGL, may be applied to the QB node, and thus, a static current flowing from the pull-up transistor M5 to the first pull-down transistor M6 may be reduced. Accordingly, the power consumption of the stage ST may be reduced.

In the embodiment, lengths of the first period P1 and the third period P3 may increase as a driving frequency of the display device including the gate driver 10 decreases, and leakage current of the input transistor M1 and the first protection transistor M7 may increase as the lengths of the first period P1 and the third period P3 increase. In the first period P1 and the third period P3, even if the signal of the Q node rises from the second low gate voltage 2VGL to the low gate voltage VGL due to the leakage current of the input transistor M1 and the first protection transistor M7, the output signal OUT may maintain the low gate voltage VGL through the second pull-down transistor M11, and accordingly, the reliability of the output signal OUT in low-frequency driving of the display device may be improved, and power consumption due to the low-frequency driving may be reduced. Further, since the output signal OUT is stably maintained at the low gate voltage VGL, the stability of the operation of the gate driver 10 may be secured.

A threshold voltage shift due to stress may occur in an oxide semiconductor transistor, and thus, the oxide semiconductor transistor may operate in a depletion mode. For a case in which the second pull-down transistor M11, which is the oxide semiconductor transistor, operates in the depletion mode, the second pull-down transistor M11 may be turned on, causing the output signal OUT to change or power consumption to increase. In the embodiment, in the second period P2, the signal of the B node may have the second low gate voltage 2VGL due to the bootstrap of the third capacitor C3, and even if the second pull-down transistor M11 operates in the depletion mode, the second pull-down transistor M11 may be turned off. Accordingly, the second pull-down transistor M11 may operate stably. Further, providing a voltage having a voltage level lower than the low gate voltage VGL to the gate driver 10 to prevent the second pull-down transistor M11 from operating in the depletion mode may be omitted, thereby preventing the number of power lines that transmit voltages to the gate driver 10 from increasing.

For a case in which the low gate voltage VGL is applied to the Q node by the reset transistor M10 turned on in response to the reset signal RST, the output signal OUT may have a voltage corresponding to the sum of the low gate voltage VGL and a threshold voltage of the first pull-down transistor M6. In the embodiment, the low gate voltage VGL may be transmitted to the output terminal T_OUT through the second pull-down transistor M11, and accordingly, the output signal OUT may decrease to the low gate voltage VGL. Accordingly, when the gate driver 10 is reset, the output signal OUT may have the low gate voltage VGL.

In the embodiment of FIGS. 2-8, a second pull-down transistor M11 is included in addition to the first pull-down transistor T6 to improve reliability of the output signal OUT. The embodiment also modifies voltages at both the control node Q of the first pull-down transistor M6 and the control node QB of the pull-up transistor T5. The resultant is a reliable output signal OUT where no intermediate level between a low gate voltage VGL and a high gate voltage VGH is output, where such a reliable output signal OUT can be achieved even at a low driving frequency, where power consumption is reduced, and where additional input voltages into each stage are not required.

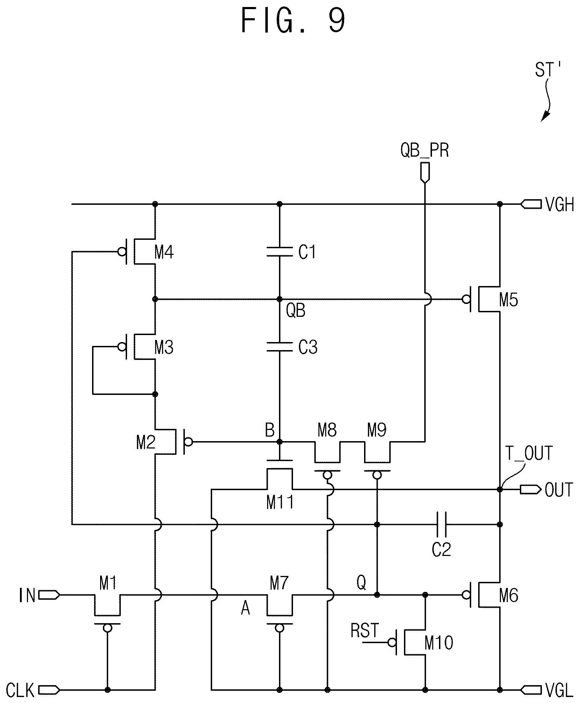

FIG. 9 is a circuit diagram illustrating an example of the stage ST' included in the gate driver 10 of FIG. 1.

Referring to FIG. 9, the stage ST' may include an input transistor M1, a second control transistor M2, a third control transistor M3, a fourth control transistor M4, a pull-up transistor M5, a first pull-down transistor M6, a first protection transistor M7, a second protection transistor M8, a first control transistor M9, a reset transistor M10, a second pull-down transistor M11, a first capacitor C1, a second capacitor C2, and a third capacitor C3. To the extent that stage ST' is not described in detail with respect to FIG. 9, it may be understood that stage ST' is at least similar to stage ST of FIG. 2 within the disclosure.

The second control transistor M2 may transmit the clock signal CLK to the gate and the first terminal of the third control transistor M3 in response to the signal of the B node. The second control transistor M2 may include a gate connected to the B node, a first terminal that receives the clock signal CLK, and a second terminal connected to the gate and the first terminal of the third control transistor M3.

The third control transistor M3 may include a gate connected to the second terminal of the second control transistor M2, a first terminal connected to the second terminal of the second control transistor M2, and a second terminal connected to the QB node. The third control transistor M3 may be diode-connected. For a case in which the clock signal CLK has the low gate voltage VGL, a voltage corresponding to the sum of the low gate voltage VGL and a threshold voltage of the third control transistor M3 may be applied to the QB node.

A gate parasitic capacitance may exist at a gate of a transistor, and a first terminal parasitic capacitance may exist at a first terminal of the transistor. In an embodiment described with reference to FIG. 2, a line that transmits the clock signal CLK may be connected to the gate and the first terminal of the second control transistor M2, and thus, a parasitic capacitance seen in the clock signal CLK may correspond to the sum of a gate parasitic capacitance of the second control transistor M2 and a first terminal parasitic capacitance of the second control transistor M2.

In the embodiment described with reference to FIG. 9, a line that transmits the clock signal CLK may be connected only to the first terminal of the second control transistor M2, and thus, the parasitic capacitance seen in the clock signal CLK may correspond to a first terminal parasitic capacitance of the second control transistor M2. Accordingly, the parasitic capacitance seen in the clock signal CLK may be reduced, and thus, power consumption by the clock signal CLK may be reduced.

The third capacitor C3 may be connected between the B node and the QB node. The third capacitor C3 may include a first terminal connected to the B node and a second terminal connected to the QB node. The third capacitor C3 may bootstrap the signal of the B node when the signal of the QB node changes.

In an embodiment described with reference to FIG. 2, only the first capacitor C1 may be connected to the QB node. For a case in which the clock signal CLK is transmitted to the QB node through the second control transistor M2 and the third control transistor M3, a capacitance seen in the clock signal CLK may correspond to a capacitance of the first capacitor C1.

In the embodiment described with reference to FIG. 9, the first capacitor C1 and the third capacitor C3 may be connected to the QB node. For a case in which the clock signal CLK is transmitted to the QB node through the second control transistor M2 and the third control transistor M3, a capacitance seen in the clock signal CLK may correspond to the sum of the capacitance of the first capacitor C1 and the capacitance of the third capacitor C3. Accordingly, the capacitance seen in the clock signal CLK may increase, and a falling time of the clock signal CLK may increase.

In the embodiment of FIG. 9 as compared to the embodiment of FIG. 2, the parasitic capacitance of the clock signal CLK may be reduced to reduce power consumption, while the capacitance seen in the clock signal CLK may increase to increase a falling time of the clock signal CLK.

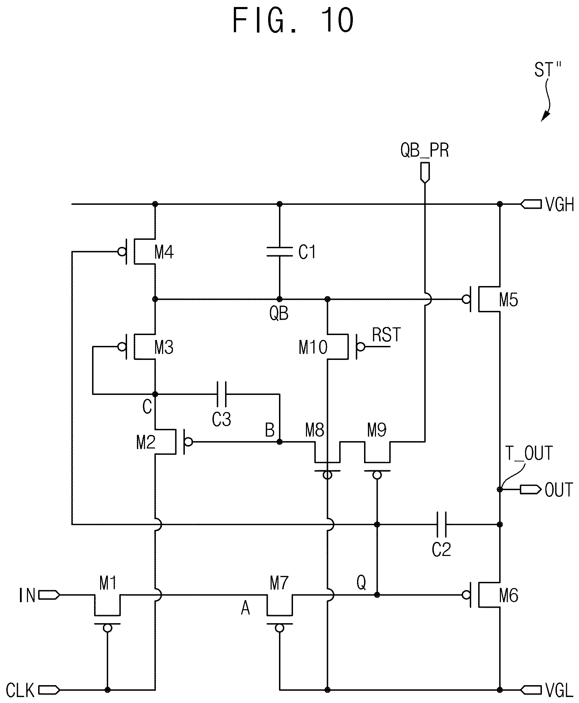

FIG. 10 is a circuit diagram illustrating an example of the stage ST" included in the gate driver 10 of FIG. 1.

Referring to FIG. 10, the stage ST" may include an input transistor M1, a second control transistor M2, a third control transistor M3, a fourth control transistor M4, a pull-up transistor M5, a first pull-down transistor M6, a first protection transistor M7, a second protection transistor M8, a first control transistor M9, a reset transistor M10, a first capacitor C1, a second capacitor C2, and a third capacitor C3. To the extent that stage ST" is not described in detail with respect to FIG. 10, it may be understood that stage ST" is at least similar to stage ST' of FIG. 9 within the disclosure.

The reset transistor M10 may transmit the low gate voltage VGL to the QB node in response to the reset signal RST. The reset transistor M10 may include a gate that receives the reset signal RST, a first terminal that receives the low gate voltage VGL, and a second terminal connected to the QB node.

The third capacitor C3 may be connected between the B node and the C node. The third capacitor C3 may include a first terminal connected to the B node and a second terminal connected to the C node. The third capacitor C3 may bootstrap the signal of the B node when the signal of the C node changes.

For a case in which leakage current of the input transistor M1 and the first protection transistor M7 is not large, even if a driving frequency of the display device decreases, the output signal OUT may maintain the low gate voltage VGL in the first period P1 of FIG. 3 and the third period P3 of FIG. 3. In the embodiment, the stage ST" might not include the second pull-down transistor M11 of FIGS. 2 and 9 that maintains the output signal OUT at the low gate voltage VGL. The stage ST" may include only PMOS transistors M1, M2, M3, M4, M5, M6, M7, M8, M9, M10, which are polycrystalline silicon transistors, and accordingly, the number of masks for manufacturing the stage ST" may be reduced. Accordingly, manufacturing time and manufacturing cost of the display device may be reduced.

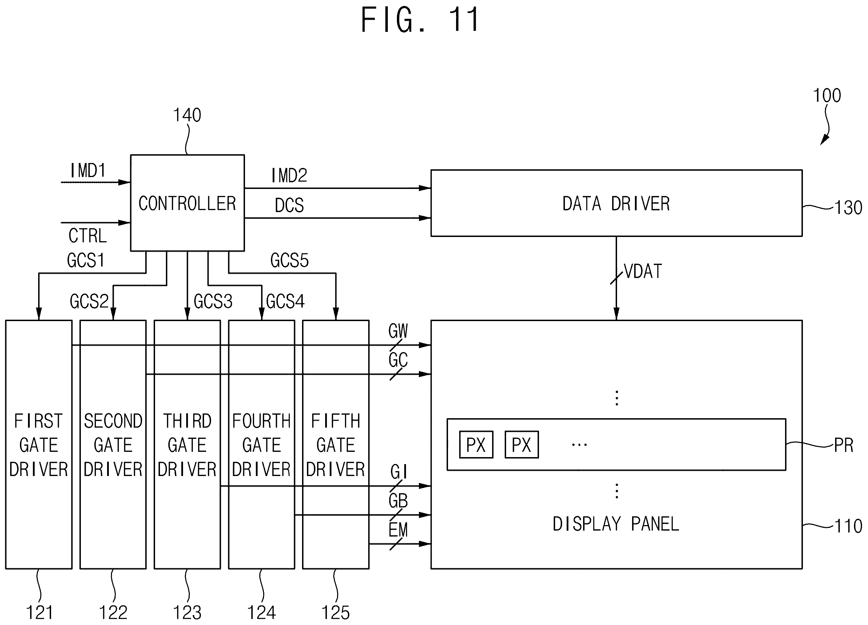

FIG. 11 is a block diagram illustrating a display device 100 according to an embodiment.

Referring to FIG. 11, the display device 100 may include a display panel 110, a first gate driver 121, a second gate driver 122, a third gate driver 123, a fourth gate driver 124, a fifth gate driver 125, a data driver 130, and a controller 140.

The display panel 110 may include pixel rows PR. Each of the pixel rows PR may include pixels PX.

The first gate driver 121 may include stages that output write gate signals GW to the pixel rows PR. The first gate driver 121 may be referred to as a write gate driver. The first gate driver 121 may generate the write gate signals GW based on a first gate control signal GCS1. The first gate control signal GCS1 may include a write gate start signal, a write gate clock signal, etc.

The second gate driver 122 may include stages that output compensation gate signals GC to the pixel rows PR. The second gate driver 122 may be referred to as a compensation gate driver. The second gate driver 122 may generate the compensation gate signals GC based on a second gate control signal GCS2. The second gate control signal GCS2 may include a compensation gate start signal, a compensation gate clock signal, etc.

The third gate driver 123 may include stages that output initialization gate signals GI to the pixel rows PR. The third gate driver 123 may be referred to as an initialization gate driver. The third gate driver 123 may generate the initialization gate signals GI based on a third gate control signal GCS3. The third gate control signal GCS3 may include an initialization gate start signal, an initialization gate clock signal, etc.

The fourth gate driver 124 may include stages that output bypass gate signals GB to the pixel rows PR. The fourth gate driver 124 may be referred to as a bypass gate driver. The fourth gate driver 124 may generate the bypass gate signals GB based on a fourth gate control signal GCS4. The fourth gate control signal GCS4 may include a bypass gate start signal, a bypass gate clock signal, etc.

The fifth gate driver 125 may include stages that output emission control signals EM to the pixel rows PR. The fifth gate driver 125 may be referred to as an emission control driver. The fifth gate driver 125 may generate the emission control signals EM based on a fifth gate control signal GCS5. The fifth gate control signal GCS5 may include an emission control start signal, an emission control clock signal, etc.

In an embodiment, the gate driver 10 of FIG. 1 may be one of the second gate driver 122, the third gate driver 123, the fourth gate driver 124, and the fifth gate driver 125.

The data driver 130 may output data voltages VDAT to the pixels PX. The data driver 130 may generate the data voltages VDAT based on output image data IMD2 and a data control signal DCS. The data driver 130 may convert the output image data IMD2 in a digital format into the data voltages VDAT in an analog format. The data control signal DCS may include a load signal, a data clock signal, an output data enable signal, etc.

The controller 140 may control the first gate driver 121, the second gate driver 122, the third gate driver 123, the fourth gate driver 124, the fifth gate driver 125, and the data driver 130. The controller 140 may output the first gate control signal GCS1 to the first gate driver 121, may output the second gate control signal GCS2 to the second gate driver 122, may output the third gate control signal GCS3 to the third gate driver 123, may output the fourth gate control signal GCS4 to the fourth gate driver 124, may output the fifth gate control signal GCS5 to the fifth gate driver 125, and may output the output image data IMD2 and the data control signal DCS to the data driver 130. The controller 140 may generate the first gate control signal GCS1, the second gate control signal GCS2, the third gate control signal GCS3, the fourth gate control signal GCS4, the fifth gate control signal GCS5, the output image data IMD2, and the data control signal DCS based on input image data IMD1 and a control signal CTRL. The controller 140 may convert the input image data IMD1 into the output image data IMD2. The control signal CTRL may include a vertical synchronization signal, a horizontal synchronization signal, an input data enable signal, a master clock signal, etc.

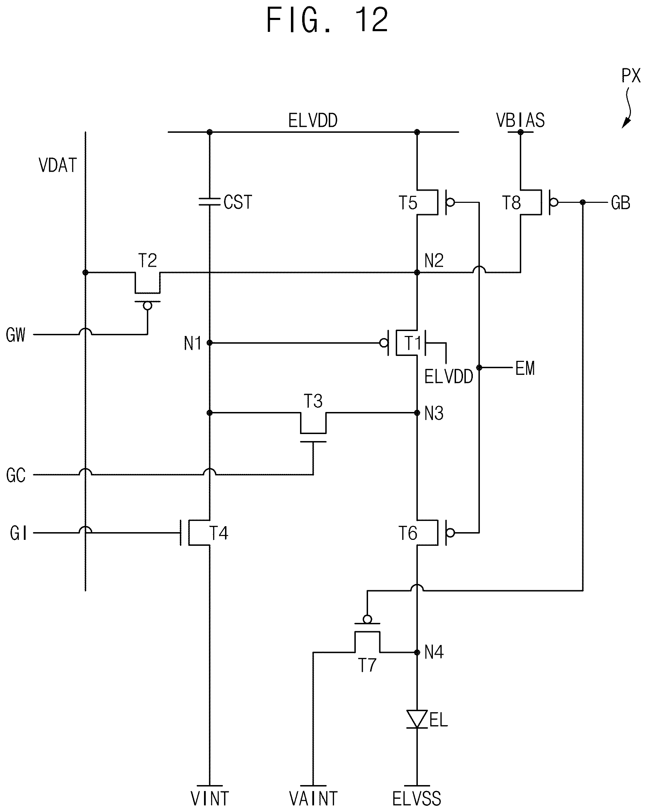

FIG. 12 is a circuit diagram illustrating the pixel PX of FIG. 11.

Referring to FIG. 12, the pixel PX may include a first transistor T1, a second transistor T2, a third transistor T3, a fourth transistor T4, a fifth transistor T5, a sixth transistor T6, a seventh transistor T7, a storage capacitor CST, and a light-emitting element EL. In an embodiment, the pixel PX may further include an eighth transistor T8.

The first transistor T1 may include a gate connected to a first node N1, a first terminal connected to a second node N2, and a second terminal connected to a third node N3. In an embodiment, the first transistor T1 may further include a body (or back gate) that receives a first power voltage ELVDD. The first terminal of the first transistor T1 may be a first of a source and a drain, and the second terminal of the first transistor T1 may be another of the source and the drain.

The second transistor T2 may transmit the data voltage VDAT to the second node N2 in response to the write gate signal GW. The second transistor T2 may include a gate that receives the write gate signal GW, a first terminal that receives the data voltage VDAT, and a second terminal connected to the second node N2. The first terminal of the second transistor T2 may be a first of a source and a drain, and the second terminal of the second transistor T2 may be another of the source and the drain.

The third transistor T3 may connect the first node N1 to the third node N3 in response to the compensation gate signal GC. The third transistor T3 may include a gate that receives the compensation gate signal GC, a first terminal connected to the first node N1, and a second terminal connected to the third node N3. The first terminal of the third transistor T3 may be a first of a source and a drain, and the second terminal of the third transistor T3 may be another of the source and the drain.

The fourth transistor T4 may transmit a first initialization voltage VINT to the first node N1 in response to the initialization gate signal GI. The fourth transistor T4 may include a gate that receives the initialization gate signal GI, a first terminal that receives the first initialization voltage VINT, and a second terminal connected to the first node N1. The first terminal of the fourth transistor T4 may be a first of a source and a drain, and the second terminal of the fourth transistor T4 may be another of the source and the drain.

The fifth transistor T5 may transmit the first power voltage ELVDD to the second node N2 in response to the emission control signal EM. The fifth transistor T5 may include a gate that receives the emission control signal EM, a first terminal that receives the first power voltage ELVDD, and a second terminal connected to the second node N2. The first terminal of the fifth transistor T5 may be a first of a source and a drain, and the second terminal of the fifth transistor T5 may be another of the source and the drain.

The sixth transistor T6 may connect the third node N3 to a fourth node N4 in response to the emission control signal EM. The sixth transistor T6 may include a gate that receives the emission control signal EM, a first terminal connected to the third node N3, and a second terminal connected to the fourth node N4. The first terminal of the sixth transistor T6 may be a first of a source and a drain, and the second terminal of the sixth transistor T6 may be another of the source and the drain.

The seventh transistor T7 may transmit a second initialization voltage VAINT to the fourth node N4 in response to the bypass gate signal GB. The seventh transistor T7 may include a gate that receives the bypass gate signal GB, a first terminal that receives the second initialization voltage VAINT, and a second terminal connected to the fourth node N4. The first terminal of the seventh transistor T7 may be a first of a source and a drain, and the second terminal of the seventh transistor T7 may be another of the source and the drain.

The eighth transistor T8 may transmit a bias voltage VBIAS to the second node N2 in response to the bypass gate signal GB. The eighth transistor T8 may include a gate that receives the bypass gate signal GB, a first terminal that receives the bias voltage VBIAS, and a second terminal connected to the second node N2. The first terminal of the eighth transistor T8 may be a first of a source and a drain, and the second terminal of the eighth transistor T8 may be another of the source and the drain.

**The** storage capacitor CST may be connected between the first node N1 and a power line that transmits the first power voltage ELVDD. The storage capacitor CST may include a first terminal connected to the first node N1 and a second terminal that receives the first power voltage ELVDD. The storage capacitor CST may store a signal of the first node N1.

The light-emitting element EL may include a first terminal (or anode) connected to the fourth node N4 and a second terminal (or cathode) that receives a second power voltage ELVSS. The light-emitting element EL may emit light with a luminance corresponding to a magnitude of a driving current generated from the first transistor T1.

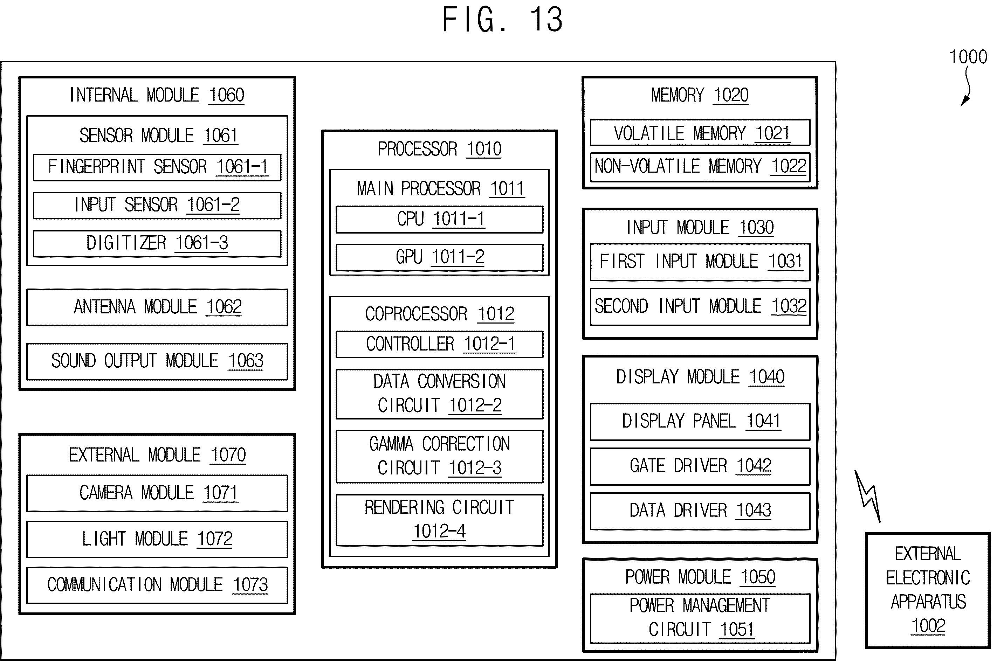

FIG. 13 is a block diagram illustrating an electronic apparatus 1000 according to an embodiment.

Referring to FIG. 13, the electronic apparatus 1000 may output various information through a display module 1040 through an operating system. For a case in which a processor 1010 executes an application stored in a memory 1020, the display module 1040 may provide application information to a user through a display panel 1041. In other words, the processor 1010 may control the display module 1040. In an embodiment, the processor 1010 may provide the input image data IMD1 of FIG. 11 and the control signal CTRL of FIG. 11 to the display module 1040.

The processor 1010 may obtain an external input through an input module 1030 or a sensor module 1061, and may execute an application corresponding to the external input. For example, for a case in which the user selects a camera icon displayed on the display panel 1041, the processor 1010 may obtain a user input through an input sensor 1061-2, and may activate a camera module 1071. The processor 1010 may transmit image data corresponding to a captured image acquired through the camera module 1071 to the display module 1040. The display module 1040 may display an image corresponding to the captured image through the display panel 1041. Some of components of the electronic apparatus 1000 may be a single, uninterrupted structure and provided as one (e.g., a single) component, or a component may be provided separately into two or more components.

The electronic apparatus 1000 may communicate with an external electronic apparatus 1002 through a network (e.g., a short-range wireless communication network or a long-range wireless communication network). In an embodiment, the electronic apparatus 1000 may include the processor 1010, the memory 1020, the input module 1030, the display module 1040, a power module 1050, an internal module 1060, and an external module 1070. In an embodiment, the electronic apparatus 1000 may omit at least one of the above-described components, or one or more other components may be added. In an embodiment, some of the above-described components (e.g., a sensor module 1061, an antenna module 1062, or a sound output module 1063) may be integrated into another component (e.g., the display module 1040).

The processor 1010 may execute software to control at least one other component (e.g., hardware or software component) of the electronic apparatus 1000 connected to the processor 1010, and may perform various data processing or calculation. In an embodiment, as at least part of data processing or calculation, the processor 1010 may store commands or data received from another component (e.g., the input module 1030, the sensor module 1061, or a communication module 1073) in a volatile memory 1021, may process the commands or data stored in the volatile memory 1021, and may store resultant data in a non-volatile memory 1022.

**The** processor 1010 may include a main processor 1011 and a coprocessor 1012. The main processor 1011 may include one or more of a central processing unit (CPU) 1011-1 or an application processor (AP). The main processor 1011 may further include one or more of a graphics processing unit (GPU) 1011-2, a communication processor (CP), and an image signal processor (ISP). At least two of the above-described processing unit and processor may be implemented as a single, uninterrupted structure (e.g., a single chip), or each may be implemented as an independent component (e.g., multiple chips).

**The** coprocessor 1012 may include a controller 1012-1. The controller 1012-1 may include an interface conversion circuit and a timing control circuit. The controller 1012-1 may receive an image signal from the main processor 1011, may convert data format of the image signal to suit the interface specifications with the display module 1040, and may output image data. The controller 1012-1 may output various control signals desirable for driving the display module 1040.

The coprocessor 1012 may further include a data conversion circuit 1012-2, a gamma correction circuit 1012-3, a rendering circuit 1012-4, etc. The data conversion circuit 1012-2 may receive the image data from the controller 1012-1, and may compensate the image data such that the image is displayed at a desired luminance according to the characteristics of the electronic apparatus 1000 or the user's settings or may convert the image data to reduce power consumption or compensate for afterimages. The gamma correction circuit 1012-3 may convert the image data or a gamma reference voltage such that an image displayed on the electronic apparatus 1000 has desired gamma characteristics. The rendering circuit 1012-4 may receive the image data from the controller 1012-1, and may render the image data by considering a pixel arrangement of the display panel 1041 applied to the electronic apparatus 1000. At least one of the data conversion circuit 1012-2, the gamma correction circuit 1012-3, and the rendering circuit 1012-4 may be integrated into another component (e.g., the main processor 1011 or a controller). At least one of the data conversion circuit 1012-2, the gamma correction circuit 1012-3, and the rendering circuit 1012-4 may be integrated into a data driver 1043 to be described below.

The memory 1020 may store various data used by at least one component of the electronic apparatus 1000 (e.g., the processor 1010 or the sensor module 1061) and input data or output data for commands related thereto. The memory 1020 may include at least one of the volatile memory 1021 and the non-volatile memory 1022.

The input module 1030 may receive commands or data to be used in components of the electronic apparatus 1000 (e.g., the processor 1010, the sensor module 1061, or the sound output module 1063) from an exterior of the electronic apparatus 1000 (e.g., the user or the external electronic apparatus 1002).

The input module 1030 may include a first input module 1031 through which commands or data are input from the user, and a second input module 1032 through which command or data are input from the external electronic apparatus 1002. The first input module 1031 may include a microphone, a mouse, a keyboard, a key (e.g., button), or a pen (e.g., passive pen or active pen). The second input module 1032 may support a designated protocol that may connect to the external electronic apparatus 1002 by wire or wirelessly. In an embodiment, the second input module 1032 may include a high definition multimedia interface (HDMI), a universal serial bus (USB) interface, an SD card interface, or an audio interface. The second input module 1032 may include a connector that may be physically connected to the external electronic apparatus 1002, for example, an HDMI connector, a USB connector, an SD card connector, or an audio connector (e.g., a headphone connector).

The display module 1040 may provide visual information to the user. The display module 1040 may include the display panel 1041, a gate driver 1042, and the data driver 1043. The display module 1040 may further include a window, a chassis, and a bracket to protect the display panel 1041. The display module 1040 may correspond to the display device 100 of FIG. 11. The display panel 1041 may correspond to the display panel 110 of FIG. 11, the gate driver 1042 may correspond to the first gate driver 121 of FIG. 11, the second gate driver 122 of FIG. 11, the third gate driver 123 of FIG. 11, the fourth gate driver 124 of FIG. 11, and/or the fifth gate driver 125 of FIG. 11, and the data driver 1043 may correspond to the data driver 130 of FIG. 11.

The power module 1050 may supply power to components of the electronic apparatus 1000. The power module 1050 may include a battery that charges power voltage. The battery may include a non-rechargeable primary cell, a rechargeable secondary cell, or a fuel cell. The power module 1050 may include a power management circuit 1051. The power management circuit 1051 may supply optimized power to each of the above-described modules and the modules described below. The power module 1050 may include a wireless power transmission/reception member electrically connected to the battery. The wireless power transmission/reception member may include multiple coil-shaped antenna radiators.

The electronic apparatus 1000 may further include the internal module 1060 and the external module 1070. The internal module 1060 may include the sensor module 1061, the antenna module 1062, and the sound output module 1063. The external module 1070 may include the camera module 1071, a light module 1072, and a communication module 1073.

The sensor module 1061 may detect an input by the user's body or an input by the pen among the first input module 1031, and may generate an electrical signal or a data value corresponding to the input. The sensor module 1061 may include at least one of a fingerprint sensor 1061-1, an input sensor 1061-2, and a digitizer 1061-3.

**The** processor 1010 may output commands or data to the display module 1040, the sound output module 1063, the camera module 1071, or the light module 1072 based on the input data received from the input module 1030. For example, the processor 1010 may generate image data in response to input data applied through the mouse or the active pen and output the image data to the display module 1040, or may generate command data in response to the input data to output the command data to the camera module 1071 or the light module 1072. For a case in which no input data is received from the input module 1030 for a certain period of time, the processor 1010 may switch an operation mode of the electronic apparatus 1000 to a low-power mode or a sleep mode to reduce power consumption of the electronic apparatus 1000.

The processor 1010 may output commands or data to the display module 1040, the sound output module 1063, the camera module 1071, or the light module 1072 based on sensing data received from the sensor module 1061. For example, the processor 1010 may compare authentication data authorized by the fingerprint sensor 1061-1 with authentication data stored in the memory 1020, and then may execute an application according to the comparison result. The processor 1010 may execute command or output corresponding image data to the display module 1040 based on sensing data detected by the input sensor 1061-2 or the digitizer 1061-3. For a case in which the sensor module 1061 includes a temperature sensor, the processor 1010 may receive temperature data for a temperature measured from the sensor module 1061, and may further perform luminance correction for the image data or the like based on the temperature data.

The display device according to the embodiments may be applied to a display device included in a computer, a notebook, a mobile phone, a smart phone, a smart pad, a smart watch, a PMP, a PDA, an MP3 player, or the like.

Embodiments of the disclosure relate to a gate driver, a display device that includes the same and an electronic apparatus that includes the same where the gate driver includes multiple stages. Each of the stages may include a circuit that avoids outputting an intermediate voltage between a high gate voltage VGH and a low gate voltage VGL so that reliability is improved. The stage circuit includes an output terminal disposed between a pull-up transistor M5 and pull-down transistors M6 and M11. Second pull-down transistor M11 may be included to prevent the output voltage from rising above a low voltage level to an intermediate level. The second pull-down transistor M11 is electrically connected in parallel to the first pull-down transistor M6. The stage circuit includes a QB node that is a control node for (i.e., connected to the gate of) the pull-up transistor M5, a Q node connected to the gate of the first pull-down transistor M6, and a B node connected to the gate of the second pull-down transistor M11.

Upon being driven in low frequency driving where the control (or Q) node of the first pull down transistor M6 rises to a low gate voltage VGL due to leakage current of input transistors M1 and M7, the output signal OUT may still be maintained at the low gate voltage VGL. For a case in which the second pull-down transistor M11 is operated in depletion mode, a signal of B node may have a second low gate voltage 2VGL to turn off the second pull-down transistor M11 to reduce static current flowing through second pull-down transistor M11 to conserve power. Also, a third voltage is not required to drive the gate driver, thereby reducing complexity of a power voltage generator.

Although the gate driver, the display device, and the electronic apparatus according to the embodiments have been described with reference to the drawings, the illustrated embodiments are examples, and may be modified and changed by a person having ordinary knowledge in the relevant technical field without departing from the technical scope as defined by the appended claims.

## Claims

1. A gate driver (10, 1042) comprising a plurality of stages (ST),
wherein each of the plurality of stages (ST) comprises:
an input transistor (M1) configured to transmit an input signal (IN) to a Q node in response to a clock signal (CLK);
an output terminal (T_OUT) to output an output signal (OUT), the output terminal (T_OUT) is disposed between a pull-up transistor (M5) and each of a first pull-down transistor (M5) and a second pull-down transistor (M11);
the pull-up transistor (M5) configured to output a high gate voltage (VGH) as the output signal (OUT) in response to a signal of a QB node, the QB node is connected to a gate of the pull-up transistor (M5);
the first pull-down transistor (M5) configured to output a low gate voltage (LGV) as the output signal (OUT) in response to a signal of the Q node;
the second pull-down transistor (M11) is configured to output the low gate voltage (LGV) as the output signal (OUT) in response to a signal of a B node, the B node is connected to a gate of the second pull-down transistor (M11); and
a first control transistor (M9) configured to transmit a signal of a QB node of a previous stage (ST) to the B node in response to the signal of the Q node, the Q node is connected to both of a gate of the first pull-down transistor (M5) and a gate of the first control transistor (M9).

2. The gate driver (10, 1042) of claim 1, wherein each of the plurality of stages (ST) further comprises:
a second control transistor (M2) comprising a gate configured to receive the clock signal (CLK), a first terminal configured to receive the clock signal (CLK), and a second terminal connected to a C node,
the C node to produce and apply a voltage corresponding to a sum of the low gate voltage (LGV) received from the clock signal (CLK) and a threshold voltage (V_{TH}) of the second control transistor (M2) to the QB node.

3. The gate driver (10, 1042) of claim 2, wherein each of the plurality of stages (ST) further comprises:
a third control transistor (M3) configured to connect the QB node to the C node in response to the signal of the B node.

4. The gate driver (10, 1042) of claim 3, wherein the voltage corresponding to a sum of the low gate voltage (LGV) and the threshold voltage (V_{TH}) of the second control transistor (M2) is applied to the QB node through the second control transistor (M2) and the third control transistor (M3) when the input signal (IN) has the high gate voltage (VGH) and the clock signal (CLK) has the low gate voltage (LGV).

5. The gate driver of any one of the preceding claims, wherein each of the plurality of stages (ST) further comprises:
a fourth control transistor (M4) configured to transmit the high gate voltage (VGH) to the QB node in response to the signal of the Q node; and/or
a reset transistor (M10) configured to transmit the low gate voltage (LGV) to the Q node in response to a reset signal.

6. The gate driver (10, 1042) of any one of the preceding claims, wherein each of the plurality of stages (ST) further comprises:
a first protection transistor (M7) comprising a gate configured to receive the low gate voltage (LGV), a first terminal connected to a second terminal of the input transistor (M1), and a second terminal connected to the Q node; and/or
a second protection transistor (M8) comprising a gate configured to receive the low gate voltage (LGV), a first terminal connected to a second terminal of the first control transistor (M9), and a second terminal connected to the B node.

7. The gate driver (10, 1042) of any one of the preceding claims, wherein each of the plurality of stages (ST) further comprises:
a first capacitor (C1) comprising a first terminal connected to the QB node and a second terminal configured to receive the high gate voltage (VGH); and/or
a second capacitor (C2) comprising a first terminal connected to the Q node and a second terminal connected to the output terminal (T_OUT) configured to output the output signal (OUT); and/or
a third capacitor (C3) connected between the B node and the C node.

8. The gate driver (10, 1042) of any one of the preceding claims, wherein the signal of the Q node transitions from the high gate voltage (VGH) to a voltage lower than the low gate voltage (LGV) when the input signal (IN) has the low gate voltage (LGV), when the clock signal (CLK) has the low gate voltage (LGV), and when the output signal (OUT) transitions from the high gate voltage (VGH) to the low gate voltage (LGV).

9. The gate driver (10, 1042) of claim 1, wherein each of the plurality of stages (ST) further comprises:
a second control transistor (M2) comprising a gate connected to the B node, a first terminal configured to receive the clock signal (CLK), and a second terminal.

10. The gate driver (10, 1042) of claim 9, wherein each of the plurality of stages (ST) further comprises:
a third control transistor (M3) comprising a gate connected to the second terminal of the second control transistor (M2), a first terminal connected to the second terminal of the second control transistor (M2), and a second terminal connected to the QB node; and/or
a third capacitor (C3) connected between the B node and the QB node.

11. The gate driver (10, 1042) of any one of the preceding claims, wherein
the second pull-down transistor (M11) is an n-type metal oxide semiconductor, NMOS, transistor, and
wherein each of the transistors (M1-M10) disposed in each of the plurality of stages (ST) excluding the second pull-down transistor (M11) is a p-type metal oxide semiconductor, PMOS, transistor.

12. A display device (100) comprising:
a display panel (110, 1041) comprising a plurality of pixel rows (PR), each of the plurality of pixel rows (PR) comprises a plurality of pixels (PX); and
a gate driver (10, 1042) of any one of the preceding claims, the plurality of stages (ST) of the gate driver (10, 1042) configured to output gate signals (GC) to the plurality of pixel rows (PR) .

13. The display device (100) of claim 12, wherein each of the plurality of pixels (PX) comprises:
a first transistor (T1) comprising a gate connected to a first node (N1), a first terminal connected to a second node (N2), and a second terminal connected to a third node (N3);
a second transistor (T2) configured to transmit a data voltage (VDAT) to the second node (N2) in response to a write gate signal (GW);
a third transistor (T3) configured to connect the first node (N1) to the third node (N3) in response to a compensation gate signal (GC);
a fourth transistor (T4) configured to transmit a first initialization voltage (VINT) to the first node (N1) in response to an initialization gate signal (GI);
a fifth transistor (T5) configured to transmit a first power voltage (ELVDD) to the second node (N2) in response to an emission control signal (EM);
a sixth transistor (T6) configured to connect the third node (N3) to a fourth node (N4) in response to the emission control signal (EM);
a seventh transistor (T7) configured to transmit a second initialization voltage (VAINT) to the fourth node (N4) in response to a bypass gate signal (GB);
a storage capacitor (CST) connected between the first node (N1) and a power line configured to transmit the first power voltage (VINT); and
a light-emitting element (EL) comprising a first terminal connected to the fourth node (N4) and a second terminal configured to receive a second power voltage (ELVSS),
wherein the output signal (OUT) is one of the compensation gate signal (GC), the initialization gate signal (GI), the bypass gate signal (GB), and the emission control signal (EM).

14. The display device (100) of claim 13, wherein the first pull-down transistor (M5) and the second pull-down transistor (M11) are connected in parallel.

15. An electronic apparatus (1000) comprising:
a display device (100) of any one of claims 12 to 14; and
a processor (1010) configured to control the display device (100) .

## Amended claims

### Amended claims in accordance with Rule 137(2) EPC.

1. A gate driver (10, 1042) comprising a plurality of stages (ST), wherein each of the plurality of stages (ST) comprises:
an input transistor (M1) configured to transmit an input signal (IN) to a Q node in response to a clock signal (CLK);
an output terminal (T_OUT) to output an output signal (OUT), the output terminal (T_OUT) is disposed between a pull-up transistor (M5) and each of a first pull-down transistor (M6) and a second pull-down transistor (M11);
the pull-up transistor (M5) configured to output a high gate voltage (VGH) as the output signal (OUT) in response to a signal of a QB node, the QB node is connected to a gate of the pull-up transistor (M5);
the first pull-down transistor (M6) configured to output a low gate voltage (VGL) as the output signal (OUT) in response to a signal of the Q node;
the second pull-down transistor (M11) is configured to output the low gate voltage (VGL) as the output signal (OUT) in response to a signal of a B node, the B node is connected to a gate of the second pull-down transistor (M11); and
a first control transistor (M9) configured to transmit a signal of a QB node of a previous stage (ST) to the B node in response to the signal of the Q node, the Q node is connected to both of a gate of the first pull-down transistor (M6) and a gate of the first control transistor (M9).

2. The gate driver (10, 1042) of claim 1, wherein each of the plurality of stages (ST) further comprises:
a second control transistor (M2) comprising a gate configured to receive the clock signal (CLK), a first terminal configured to receive the clock signal (CLK), and a second terminal connected to a C node,
the C node to produce and apply a voltage corresponding to a sum of the low gate voltage (VGL) received from the clock signal (CLK) and a threshold voltage (V_{TH}) of the second control transistor (M2) to the QB node.

3. The gate driver (10, 1042) of claim 2, wherein each of the plurality of stages (ST) further comprises:
a third control transistor (M3) configured to connect the QB node to the C node in response to the signal of the B node.

4. The gate driver (10, 1042) of claim 3, wherein the voltage corresponding to a sum of the low gate voltage (VGL) and the threshold voltage (V_{TH}) of the second control transistor (M2) is applied to the QB node through the second control transistor (M2) and the third control transistor (M3) when the input signal (IN) has the high gate voltage (VGH) and the clock signal (CLK) has the low gate voltage (VGL).

5. The gate driver of any one of the preceding claims, wherein each of the plurality of stages (ST) further comprises:
a fourth control transistor (M4) configured to transmit the high gate voltage (VGH) to the QB node in response to the signal of the Q node; and/or
a reset transistor (M10) configured to transmit the low gate voltage (VGL) to the Q node in response to a reset signal.

6. The gate driver (10, 1042) of any one of the preceding claims, wherein each of the plurality of stages (ST) further comprises:
a first protection transistor (M7) comprising a gate configured to receive the low gate voltage (VGL), a first terminal connected to a second terminal of the input transistor (M1), and a second terminal connected to the Q node; and/or
a second protection transistor (M8) comprising a gate configured to receive the low gate voltage (VGL), a first terminal connected to a second terminal of the first control transistor (M9), and a second terminal connected to the B node.

7. The gate driver (10, 1042) of any one of the preceding claims, wherein each of the plurality of stages (ST) further comprises:
a first capacitor (C1) comprising a first terminal connected to the QB node and a second terminal configured to receive the high gate voltage (VGH); and/or
a second capacitor (C2) comprising a first terminal connected to the Q node and a second terminal connected to the output terminal (T_OUT) configured to output the output signal (OUT); and/or
a third capacitor (C3) connected between the B node and the C node.

8. The gate driver (10, 1042) of any one of the preceding claims, wherein the signal of the Q node transitions from the high gate voltage (VGH) to a voltage lower than the low gate voltage (VGL) when the input signal (IN) has the low gate voltage (VGL), when the clock signal (CLK) has the low gate voltage (VGL), and when the output signal (OUT) transitions from the high gate voltage (VGH) to the low gate voltage (VGL).

9. The gate driver (10, 1042) of claim 1, wherein each of the plurality of stages (ST) further comprises:
a second control transistor (M2) comprising a gate connected to the B node, a first terminal configured to receive the clock signal (CLK), and a second terminal.

10. The gate driver (10, 1042) of claim 9, wherein each of the plurality of stages (ST) further comprises:
a third control transistor (M3) comprising a gate connected to the second terminal of the second control transistor (M2), a first terminal connected to the second terminal of the second control transistor (M2), and a second terminal connected to the QB node; and/or
a third capacitor (C3) connected between the B node and the QB node.

11. The gate driver (10, 1042) of any one of the preceding claims, wherein
the second pull-down transistor (M11) is an n-type metal oxide semiconductor, NMOS, transistor, and
wherein each of the transistors (M1-M10) disposed in each of the plurality of stages (ST) excluding the second pull-down transistor (M11) is a p-type metal oxide semiconductor, PMOS, transistor.

12. A display device (100) comprising:
a display panel (110, 1041) comprising a plurality of pixel rows (PR), each of the plurality of pixel rows (PR) comprises a plurality of pixels (PX); and
a gate driver (10, 1042) of any one of the preceding claims, the plurality of stages (ST) of the gate driver (10, 1042) configured to output gate signals (GC) to the plurality of pixel rows (PR).

13. The display device (100) of claim 12, wherein each of the plurality of pixels (PX) comprises:
a first transistor (T1) comprising a gate connected to a first node (N1), a first terminal connected to a second node (N2), and a second terminal connected to a third node (N3);
a second transistor (T2) configured to transmit a data voltage (VDAT) to the second node (N2) in response to a write gate signal (GW);
a third transistor (T3) configured to connect the first node (N1) to the third node (N3) in response to a compensation gate signal (GC);
a fourth transistor (T4) configured to transmit a first initialization voltage (VINT) to the first node (N1) in response to an initialization gate signal (GI);
a fifth transistor (T5) configured to transmit a first power voltage (ELVDD) to the second node (N2) in response to an emission control signal (EM);
a sixth transistor (T6) configured to connect the third node (N3) to a fourth node (N4) in response to the emission control signal (EM);
a seventh transistor (T7) configured to transmit a second initialization voltage (VAINT) to the fourth node (N4) in response to a bypass gate signal (GB);
a storage capacitor (CST) connected between the first node (N1) and a power line configured to transmit the first power voltage (VINT); and
a light-emitting element (EL) comprising a first terminal connected to the fourth node (N4) and a second terminal configured to receive a second power voltage (ELVSS),
wherein the output signal (OUT) is one of the compensation gate signal (GC), the initialization gate signal (GI), the bypass gate signal (GB), and the emission control signal (EM).

14. The display device (100) of claim 13, wherein the first pull-down transistor (M6) and the second pull-down transistor (M11) are connected in parallel.

15. An electronic apparatus (1000) comprising:
a display device (100) of any one of claims 12 to 14; and
a processor (1010) configured to control the display device (100).
